Europäisches Patentamt

European Patent Office

Office européen des brevets

(11) Veröffentlichungsnummer: **0 440 869 A1**

## EUROPÄISCHE PATENTANMELDUNG

(21) Anmeldenummer: 90102601.3

(22) Anmeldetag: 09.02.90

(51) Int. Cl.5: **H01L 31/0224**, H01L 31/05, H01L 31/048

(43) Veröffentlichungstag der Anmeldung:
14.08.91 Patentblatt 91/33

(84) Benannte Vertragsstaaten:
AT BE CH DE DK ES FR GB GR IT LI LU NL SE

(71) Anmelder: **Bio-Photonics, Inc.**
**10641 First Street East**
**Treasure Island Florida 33706(US)**

(72) Erfinder: **Osipov, Alexandr Sergeevich**
**ulitsa Mosfilmovskaya, 32, kv.42**
**Moscow(SU)**
Erfinder: **Rubin, Leonid Borisovich**
**Lomonosovsky prospekt, 14, kv.499,**
**Moscow(SU)**
Erfinder: **Sizganov, Jury Gavrilovich**
**proezd Odoevskogo, 7, korpus 2, kv.185**
**Moscow(SU)**
Erfinder: **Untila, Gennady Grigorievich**
**Zelenograd, korpus 316, kv.28,**
**Moscow(SU)**
Erfinder: **Kharitonov, Andrei Leonidovich**
**proezd Donelaitisa, 28, kv.289**
**Moscow(SU)**
Erfinder: **Rakhimov, Alexandr Tursunovich**
**Rostovskaya naberezhnaya, 1**
**Moscow(SU)**

(74) Vertreter: **Ebbinghaus, Dieter et al**
**v. FÜNER, EBBINGHAUS, FINCK**
**Patentanwälte European Patent Attorneys**
**Mariahilfplatz 2 & 3**
**W-8000 München 90(DE)**

(54) **Photovoltaisches Bauelement zur Umwandlung des Sonnenlichts in elektrischen Strom und photoelektrische Batterie.**

(57) Das erfindungsgemäße photovoltaische Bauelement weist eine photoempfindliche Halbleiterplatte (1) mit Barrierestruktur, beiderseits der Halbleiterplatte (1) angeordnete, elektrisch leitfähige Stromabnehmerkontakte (2), beiderseits der Halbleiterplatte (1) angeordnete Schutzbeläge (3) und Stromabführungselektroden (9) auf. Mindestens die an der Vorderseite der Halbleiterplatte (1) angeordneten elektrisch leitfähigen Stromabnehaerkontakte (2) sind in Form von elektrisch verbundenen und aufeinanderfolgenden Abschnitten ausgeführt, die mit der Oberfläche der Halbleiterplatte (1) in Kontakt bzw. nicht in Kontakt stehen.

## PHOTOVOLTAISCHES BAUELEMENT ZUR UMWANDLUNG DES SONNENLICHTS IN ELEKTRISCHEN STROM UND PHOTOELEKTRISCHE BATTERIE

Die Erfindung bezieht sich auf die Halbleiterelektronik und zwar auf die Photovoltaik und kann zum Bau von photovoltaischen Halbleiterwandlern eingesetzt werden.

Bekannt sind Bauelemente zur Umwandlung von Lichtenergie in elektrische Energie (Photozellen), die eine Halbleiterplatte mit einer Barrierestruktur, beiderseits der Platte angeordnete, elektrisch leitfähige Stromabnehmerelemente, Schutzbeschichtungen sowie Stromabführelektroden aufweisen. Eines der Konstruktionselemente der photovoltaischen Halbleiterwandler sind Stromabnehmerkontakte.

Gegenwärtig werden bei photovoltaischen Halbleiter-Bauelementen Stromabnehmerkontakte verwendet, die durch ein Vakuumaufdampfverfahren über eine Maske gefertigt werden (siehe A. Fahrenbruch, R. Bjub Solarzellen. Theorie und Experiment, Moskau, Energoatomverlag, 1987, S. 169).

Beim Vakuumaufdampfen werden Metalle wie Aluminium, Titan, Palladium, Kupfer und Silber aufgetragen. Dabei ist die obere Schicht aus Kupfer oder Silber ausgeführt. Nach dem Aufdampfen wird auf die Kontakte Lot aufgetragen, das Zinn und Blei enthält. Bei der Verwendung von aufgedampften Kontakten bei photovoltaischen Bauelementen wird somit eine bedeutende Menge an teuren Metallen und an Energie verbraucht.

Aus der US-PS 4 235 644 sind photovoltaische Halbleiter-Bauelemente bekannt, bei denen die Stromabnehmerkontakte mittels eines Siebdruckverfahrens gefertigt sind. Die elektrisch leitfähige Paste, mit Silberpulver als Füllstoff, wird mit einer Walze über die Maske auf die Oberfläche der Halbleiterplatte aufgetragen. Nach dem Abnehmen der Maske werden die Kontakte geglüht.

Ein Nachteil photovoltaischer Bauelemente mit aufgedampften Kontakten sowie mit durch Siebdruckverfahren gefertigten Kontakten ist, daß es praktisch nicht gelingt, Kontaktschienen dünner als 0,2 mm herzustellen.

Ein Netz solcher Kontakte, die auf die Oberfläche der Halbleiterplatte aufgetragen sind, läßt es nicht zu, eine Beschattungsfläche der Oberfläche der Halbleiterplatte von weniger als 5 % der Gesamtfläche zu erhalten. Dies begrenzt die Möglichkeit einer Erhöhung des Umwandlungswirkungsgrades des photovoltaischen Bauelementes. Außerdem wird bei der Fertigung einer Batterie mit photovoltaischen Bauelementen, in deren Konstruktion aufgedampfte Abnehmerkontakte bzw. durch Siebdruckverfahren gefertigte Kontakte eingesetzt werden, das Umschalten der photovoltaischen Bauelemente zu einer komplizierten, arbeitsaufwendigen Operation, die entweder manuell oder mittels kostspieliger Ausrüstungen ausgeführt wird.

Aus der US-PS 4 380 112 ist ein weiteres photovoltaisches Bauelement bekannt. Dieses Bauelement besteht aus einer Halbleiter-Siliziumplatte mit Barriere- oder Schichtstruktur, einem ganzflächigen Metallkontakt an der Rückseite sowie einem Stromabnehmerkontakt an der Vorderseite. Der vordere Stromabnehmerkontakt (auf der Seite, die auf das auffallende Licht gerichtet ist) stellt einen Metalldraht dar, der in Borsilikatglas hineinlegiert ist und die Oberfläche der Halbleiterplatte direkt berührt. Weil das Glas elektrostatisch an die Oberfläche der Halbleiterplatte angeklebt ist und die ganze Konstruktion auf eine Temperatur erwärmt wird, bei der sich eine merkliche Diffusion des Drahtmetalls in den Halbleiter vollzieht, wird zwischen der Halbleiterplatte und dem Stromabnehmer ein fester Kontakt gewährleistet.

Ein Nachteil einer solchen Konstruktion ist wegen der Beschattung der Oberfläche der Halbleiterplatte ein niedriger Umwandlungs-Wirkungsgrad. Dabei beträgt die Beschattungsfläche ebenfalls nicht weniger als 5 % der Gesamtfläche der Halbleiteroberfläche. Außerdem ist diese Konstruktion im Vergleich zu den beiden ersten teurer, weil hier das teure Borsilikatglas verwendet wird, das den Forderungen der Anpassung der thermomechanischen Eigenschaften der Siliziumplatte und des Schutzglases entspricht. Diese Konstruktion erfordert ein vorläufiges Polieren der Halbleiter- und Glasplatten und ist dadurch für diejenigen Konstruktionen unannehmbar, bei denen das billige polykristalline Silizium oder das rauhe monokristalline Silizium verwendet wird. Zur Sicherung des elektrostatischen Zusammenklebens sind höhere Temperaturen bis 600°C erforderlich.

Außerdem ist bei dieser Konstruktion eine nachfolgende hermetische Abdichtung des ganzen photovoltaischen Bauelements mittels eines dichten Polymers und Schutzgläser erforderlich. Die Verbindung von photovoltaischen Bauelementen einer derartigen Konstruktion erfolgt üblicherweise mittels Verbindung von Drähten auf den vorderseitigen Drahtkontakten und auf den rückseitigen Metallkontakten durch Löten. Es ist recht kompliziert, dieses Verfahren zu automatisieren.

Der Erfindung liegt die Aufgabe zugrunde, die durch die Stromabnehmerkontakte verursachte Abschattung der Oberfläche der Halbleiterplatten zu reduzieren und dadurch den Umwandlungswirkungsgrad des photovoltaischen Bauelements zu erhöhen, sowie auf der Grundlage von neuen Stromabnehmerkontakten die Verbindung sowohl der Solarzellen als auch auf ihrer Basis montierter Batterien zu vereinfachen, wobei man auf Löten der Schaltkontakte und Schaltschienen verzichten kann. Das wiederum ermöglicht es, den Fertigungsvorgang von photovoltaischen Bauelementen und Batterien auf ihrer Grundlage zu automatisieren und den Fertigungsvorgang im ganzen wesentlich zu vereinfachen und billiger zu machen.

Erfindungsgemäß wird diese Aufgabe dadurch gelöst, daß bei photovoltaischen Bauelementen zur Umwandlung von Lichtenergie in elektrischen Strom das elektrisch leitfähige Stromabnehmerelement, das mindestens auf der Vorderseite der Halbleiterplatte angeordnet ist, aus miteinander elektrisch verbundenen und aufeinanderfolgenden Abschnitten besteht, die abwechselnd die Oberfläche der Halbleiterplatte berühren bzw nicht berühren.

Da ein Teil des Stromabnehmerelementes über die Oberfläche der Halbleiterplatte "angehoben ist" und auf diese Oberfläche unter anderem auch die zerstreute Lichtenergie fällt, erhöht sich der Umwandlungswirkungsgrad des ganzen photovoltaischen Baulements.

Wenn das photovolaische Bauelement auf der Rückseite der Halbleiterplatte einen Isotypieübergang aufweist und die Halbleiterplatte eine mit der Diffusionslänge von Minoritätsladungsträgern vergleichbare Dicke aufweist, wird bei Aufhellung der Rückseite des photovoltaischen Bauelements, auf der ebenfalls Stromabnehmerkontakte eingesetzt werden, beispielsweise durch gestreutes Sonnenlicht, eine zusätzliche Erhöhung des Umwandlungswirkungsgrades erreicht.

Die Konstruktion der elektrisch leitfähigen Kontakte sowie die Möglichkeit der Verbindung solcher elektrisch leitfähiger Kontakte wird in bedeutendem Maß vereinfacht, wenn solch ein Stromabnehmerkontakt beiderseits der Halbleiterplatte angeordnet ist.

Die Stromabnehmerkontakte können verschiedenste Formen aufweisen.

Sie können zum Beispiel aus einem gebogenen Draht gefertigt sein. Dabei kann die Biegung verschiedenste Form und verschiedene Biegeschritte haben. Es kann auch eine Schiene mit daran befestigten Drahtabschnitten (in Form einer Bürste) verwendet werden. Die Stromabnehmerelemente können aus Blech als ein einseitiger oder zweiseitiger Kamm ausgebildet werden.

Die Stromabnehmerelemente können nicht nur flach, sondern auch dreidimensional ausgebildet sein, zum Beispiel in Form einer zylindrischen Feder.

Außerdem können die elektrisch leitfähigen Stromabnehmerkontakte in Form eines Netzes ausgeführt sein, zum Beispiel aus Drähten, die an den Kreuzungsstellen nicht befestigt bzw. befestigt sind. Die Befestigung der Drähte an den Kreuzungsstellen ermöglicht es, die photovoltaischen Bauelemente und Batterien auf ihrer Grundlage fertigungsfreundlich zu machen.

Die elektrisch leitfähigen Stromabnehmerkontakte sind im Block eines optisch transparenten Polymermaterials auf solche Weise befestigt, daß mindestens die die Oberfläche der Halbleiterplatte berührenden Abschnitte des Stromabnehmerkontakts aus dem Block des Polymermaterials herausragen. Dies ermöglicht es, einen zuverlässigen ohmschen Kontakt der Stromabnehmerkontakte mit der Halbleiterplattezu gewährleisten, da der Polymerblock zwischen den Schutzbelägen und der Halbleiterplatte gespannt wird und die Stromabnehmerkontakte dank ihrer Elastizität einen ständigen Kontakt mit der Oberfläche der Halbleiterplatte bewahren.

Optisch transparente Polymermaterialien wie beispielsweise Poly-4-vinylbutyral oder Polyethylenvinylacetat werden weitgehend bei photovoltaischen Bauelementen zur Umwandlung von Licht in elektrische Energie eingesetzt (s. M.M. Koltun "Photovoltaische Bauelemente", Moskau, Verlag "Nauka", 1987, S. 163).

Zur Sicherung des ständigen Kontaktes und der zuverlässigen Verbindung des Polymerblocks mit den Schutzbelägen und der Halbleiterplatte wird auf den Polymerblock mit den Stromabnehmerkontakten von oben und von unten eine Schicht optisch transparenten Adhäsionsmaterials aufgetragen. Solch ein Adhäsionsmaterial verbindet sich bei Wärmebehandlung und Druckeinwirkung mit der Oberfläche des Schutzbelages und der Siliziumplatte, wodurch eine feste Verbindung entsteht.

Bevorzugt ist eine Variante, bei der der ganze Polymerblock aus einem optisch transparenten Adhäsionspolymer bzw. polymerisatonsfähigem Material ausgeführt ist. Solche Adhäsionsmaterialien wie beispielsweise Poly-4-vinylbutyral oder Polyethylenvinylacetat sind bekannt und werden in der Praxis bei der Herstellung von photovoltaischen Bauelemementen zur Sicherung einer zuverlässigen Festigkeit und Stabilität der ganzen Vorrichtung verwendet.

Zur Erhöhung des Wirkungsgrades und Reduzierung des Widerstandes an den Kontaktstellen der Stromabnehmerkontakte mit der Oberfläche der Halbleiterplatte wird die Halbleiterplatte auf der Vorderseite bzw. auf beiden Seiten, wenn der rückseitige Kontakt nicht als ein ganzflächiger Metallkontakt ausgeführt ist, mit einem elektrisch leitfähigen Antireflexbelag versehen. Solche Materialien, beispielsweise auf der Basis von SnOx, InOx, sind bekannt und werden in der Praxis bei der Herstellung von photovoltaischen Bauelementen verwendet.

Bevorzugt ist eine Variante, bei der die Rückseite der Halbleiterplatte ebenso wie die Halbleiterplatte einen Isotypieübergang aufweist, was es ermöglicht, den Reihenwiderstand niedriger zu halten, den Metallverbrauch zu reduzieren und den Umwandlungswirkungsgrad zu erhöhen.

Die elektrisch leitfähigen Stromabnehmerkontakte werden über die ganze Oberfläche der Halbleiterplatte angeordnet.

Zur Sicherung einer zuverlässigen und einfachen Verbindung von photovoltaischen Bauelementen wird eine dielektrische Platte verwendet, die mindestens an einer Seite der Halbleiterplatte angeordnet ist, wobei zum Beispiel ein Luftspalt entsteht oder zwischen der dielektrischen Platte und der Halbleiterplatte eine dielektrische Zwischenlage angeordnet ist. Diese dielektrische Platte wird von oben und von unten mit elektrisch leitfähigem Material beschichtet, woran die Stromabführungskontakte angeschlossen werden. Die dielektrische Platte liegt in einer Ebene mit der Halbleiterplatte und zwischen den Pclymerblöcken mit den darin angeordneten Stromabnehmerkontakten und gewährleistet einen zuverlässigen Kontakt mit den Stromabnehmerkontakten durch die Elastizität der Stromabnehmerkontakte und die Andrückkraft, die von den Schutzbelägen herrührt.

Am meisten ist die Ausführungsvariante einer dielektrischen Platte mit einer elektrisch leitfähigen Beschichtung der Oberflächen in Form eines Rahmens bevorzugt, der um die Halbleiterplatte herum in einer Ebene mit ihr angeordnet ist und einen Luftspalt aufweist. Im Luftspalt kann eine dielektrische Zwischenlage angeordnet werden. In diesem Fall werden keine zusätzlichen elektrisch leitfähigen Schienen zur Verbindung der Stromabnehmerkontakte benötigt, was die Konstruktion wesentlich vereinfacht und ihre Zuverlässigkeit erhöht.

Die erfindungsgemäße Konstruktion der Stromabnehmerkontakte und die auf ihrer Grundlage vorgeschlagene Konstruktion der Verbindungselemente ermöglichen es, die Montage von photovoltaischen Bauelementen zu einer Batterie in bedeutendem Maß zu vereinfachen. Dabei kann eine Parallelschaltung von mindestens zwei photovoltaischen Bauelementen gewährleistet werden, indem die elektrisch leitfähigen Stromabnehmerkontakte, die an der Vorderseite der Halbleiterplatte des einen photovoltaischen Bauelements angeordnet sind, elektrisch mit den Stromabnehmerkontakten, die an der Vorderseite der Halbleiterplatte des anderen photovoltaischen Bauelements angeordnet sind, verbunden sind, und die Stromabnehmerkontakte, die an der Rückseite der Halbleiterplatte des ersten Bauelements angeordnet sind, mit den Stromabnehmerkontakten verbunden sind, die an der Rückseite der Halbleiterplatte des zweiten photovoltaischen Bauelements angeordnet sind. Die freien Enden der Stromabnehmerkontakte beider photovoltaischer Bauelemente sind an die jeweiligen Stromabführungselektroden angeschlossen.

Bei Reihenschaltung von mindestens zwei photovoltaischen Bauelementen zu einer Batterie sind die an der Rückseite der Halbleiterplatte eines photovoltaischen Bauelements angeordneten, elektrisch leitfähigen Stromabnehmerkontakte mit den an der Vorderseite der Halbleiterplatte des nächsten photovoltaischen Bauelements angeordneten, elektrisch leitfähigen Stromabnehmerkontakten elektrisch verbunden. Die freien Enden der Stromabnehmerkontakte beider photovoltaischen Bauelemente sind an die jeweiligen Stromabführungselektroden angeschlossen.

Bei der Herstellung des photovoltaischen Bauelements können die Stromabnehmerkontakte als separate Konstruktionselemente des photovoltaischen Bauelements ausgeführt werden. Dazu werden sie zum Beispiel in einer Ebene in Form von Drähten, Spiralen oder Netzen der oben beschriebenen Konfigurationen angeordnet und anschließend in den optisch transparenten Polymerblock bei der Erweichungstemperatur des Polymers hineingeschmolzen, oder mit einer polymerisationsfähigen Komposition eingegossen und nachher zum Erstarren gebracht, wobei sie mindestens auf einer Seite aus dem Polymer hinausragen. Der so erhaltene Polymerblock mit den eingebauten Stromabnehmerkontakten kann hart oder biegsam sein, zum Beispiel als ununterbrochenes langes Band. Dabei können die Leitkontakte bezüglich der Längsachse des Bandes willkürlich angeordnet sein, das heißt, sie können zum Beispiel parallel zu jedem Paar der Photoumwandlerseiten oder unter einem Winkel dazu liegen. Das gefertigte Band kann in Stücke erforderlicher Abmessungen geschnitten werden, die eine optimale Verbindung der photovoltaischen Bauelemente gewährleisten. Dazu wird auf der Oberfläche des rückseitigen Schutzbelages, zum Beispiel Glas, ein Polymerband mit den eingebauten, elektrisch leitfähigen Kontakten aufgetragen, wonach dielektrische Rahmen mit elektrisch leitfähigen Belägen aufgelegt werden, in denen Siliziumplatten mit Barrierestruktur und Antireflexbelag angeordnet werden, worauf (wieder) ein Polymerband mit elektrisch leitfähigen Kontakten sowie der vordere Schutzbelag angebracht werden. Die schichtweise gebildete Struktur wird in einer Kammer untergebracht, aus der die Luft bis $10^{-1}$ Torr abgesaugt und nachher erwärmt (bis zum Polymerfließpunkt) und mechanisch verdichtet wird. Das geschmolzene Polymer füllt dann alle Hohlräume der Vorrichtung und verklebt alle Elemente. Dabei wird gleichzeitig (durch die richtige Anordnung der dielektrischen Rahmen, Siliziumplatten und Polymerbänder mit den Stromabnehmerkontakten) die Verbindung der einzelnen photovoltaischen Bauelemente zu einer Photobatterie gewährleistet.

Im folgenden wird die Erfindung anhand der Zeichnug erläutert; es zeigen:

Fig. 1 die schematische Darstellung eines photovoltaischen Bauelements mit den erfindungsgemäßen Stromabnehmerkontakten,

Fig. 2 die schematische Darstellung in den optisch transparenten Polymerblock eingebauter Stromabnehmerkontakte, bei denen die Abschnitte (a) die Abschnitte bezeichnen, die mit der Oberfläche der Halbleiterplatte Kontakt haben, und die Abschnitte (b) die Abschnitte bezeichnen, die mit der Oberfläche der Halbleiterplatte keinen Kontakt haben,

Fig. 3 Ausführungsbeispiele eines Stromabnehmerkontakts aus gebogenem Draht,

Fig. 4 ein Ausführungsbeispiel eines Stromabnehmerkontakts in Form einer zylindrischen Spirale,

Fig. 5 Ausführungsbeispiele von Stromabnehmerelementen aus Blech mit Vorsprüngen und Ausnehmungen,

Fig. 6 Ausführungsbeispiele von Stromabnehmerelementen in Form einer "Bürste".

Fig. 7 die Draufsicht einer Halbleiterplatte mit schematischer Darstellung von Stromabnehmerkontakten, die parallel zu einem Paar der Seiten einer Halbleiterplatte angeordnet sind,

Fig. 8 die Draufsicht einer Halbleiterplatte mit schematischer Darstellung von Stromabnehmerkontakten, die parallel zu dem anderen Paar der Seiten einer Halbleiterplatte angeordnet sind,

Fig. 9 die Draufsicht der Halbleiterplatte mit der schematischen Darstellung eines Netzes, das aus den Stromabnehmerkontakten ausgeführt ist,

Fig. 10 die schematische Darstellung eines photovoltaischen Bauelements mit elektrisch leitfähigen Schichten auf der Vorder- und Rückseite einer Halbleiterplatte,

Fig. 11 die Draufsicht einer Halbleiterplatte und einer dielektrischen Platte, die längs der Seite der Halbleiterplatte angeordnet ist,

Fig. 12 den Schnitt A-A der Fig. 11,

Fig. 13 die Draufsicht einer Halbleiterplatte und einer dielektrischen Platte, die in Form eines Rahmens ausgeführt ist,

Fig. 14 den Schnitt A-A der Fig. 13,

Fig. 15 die Draufsicht einer schematisch dargestellten dielektrischen Platte, die die Halbleiterplatte berührt, wobei die elektrisch leitfähigen Beschichtungen auf beide Seiten der dielektrischen Platte in einem gewissen Abstand zum inneren Rand der dielektrischen Platte aufgetragen sind,

Fig. 16 den Schnitt A-A der Fig. 15,

Fig. 17 die Draufsicht einer schematisch dargestellten dielektrischen Platte gemäß Fig. 15, auf die die elektrisch leitfähigen Beschichtungen in einem gewissen Abstand vom inneren und äußeren Rand der dielektrischen Lage aufgetragen sind,

Fig. 18 den Schnitt A-A der Fig. 17

Fig. 19 eine schematische Darstellung einer Batterie aus zwei parallel geschalteten photovoltaischen Bauelementen,

Fig. 20 eine schematische Darstellung einer Batterie aus zwei in Reihe geschalteter photovoltaischer Bauelemente und

Fig. 21 erfindungsgemäße mögliche Varianten der Reihenschaltung von photovoltaischen Bauelementen zu einer Batterie.

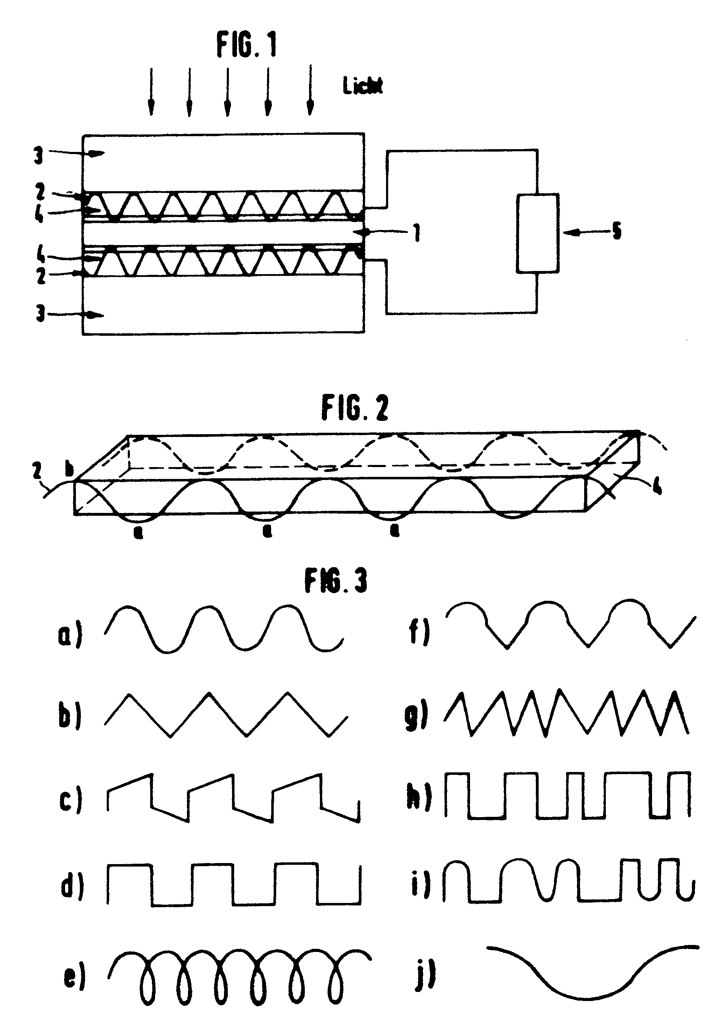

Die erfindungsgemäße Vorrichtung zur Umwandlung der Lichtenergie in die elektrische besteht aus einer Halbleiterplatte 1 mit Barriere- oder Schichtstruktur sowie aus Stromabnehmerkontakten 2, die aus elektrisch leitfähigen Metallen bzw. Legierungen ausgeführt sind. Die Stromabnehmerkontakte sind als elektrisch verbundene und aufeinanderfolgende Abschnitte ausgeführt, die mit der Halbleiterplatte 1 Kontakt haben (a) bzw. nicht haben (b) (Fig. 2). Zur Befestigung der Stromabnehmerkontakte 2 sind sie in einem optisch transparenten Polymerblock 4 so angeordnet, daß mindestens die mit der Oberfläche der Halbleiterplatte Kontakt aufweisenden Abschnitte aus dem Polymerblock herausragen. Die Stromabnehmerkontakte werden von oben und unten durch die optisch transparenten Schutzbeläge 3 angedrückt. Als Schutzbeläge 3 werden Glas oder flexible Stoffe, zum Beispiel Lawsan, verwendet.

Durch die von den Schutzbelägen 3 ausgeübten Andruckkräfte befinden sich die Stromabnehmerkontakte 2 im gespannten Zustand und bewahren an den Kontaktstellen durch ihre Elastizität ständigen Kontakt mit der Oberfläche der Halbleiterplatte 1.

Bei Belichtung des photovoltaischen Bauelements von der Vorderseite erfolgt an der energetischen Barriere eine Auftrennung der Ladungen sowie die Erzeugung einer elektromotorischen Kraft, wodurch über die auf der Vorderseite (zum Licht gerichtet) und auf der Rückseite (verdunkelt) der Halbleiterplatte 1 angeordneten Stromabnehmerkontakte ein Strom fließt, dessen Leistung am Abschlußwiderstand 5 abfällt. Ein ausreichend geringer Übergangswiderstand wird in den Kontaktstellen der Stromabnehmerkontakte 2 mit der Halbleiterplatte 1 durch die Andruckkräfte gewährleistet, die durch die Schutzbeläge 3 entstehen, sowie durch die Elastizität der Stromabnehmerkontakte 2 selbst.

Bei dem erfindungsgemäßen photovoltaischen Bauelement stehen nicht mehr als 10 % der Projektionsfläche des Stromabnehmerkontakts 2 auf die Oberfläche der Platte 1 in direktem Kontakt mit der photoempfindlichen Halbleiterplatte 1 . Das bedeutet, daß die restlichen 90 % der Projektionsfläche des Drahtes ebenfalls belichtet werden, wenn auch nicht mit senkrecht auftreffenden Lichtströmen. Diese zusätzliche Belichtung der Oberfläche der photoempfindlichen Halbleiterplatte 1 führt zur Erhöhung des Umwandlungswirkungsgrades des ganzen photovoltaischen Bauelements.

Die erfindungsgemäße Konstruktion der Stromabnehmerkontakte 2 ermöglicht es, ihre Herstellungstechnologie bedeutend zu vereinfachen, da die Phase des Einschmelzens der Stromabnehmerkontakte 2 in den optische transparenten Polymerblock 4 zu einem gesonderten Vorgang abgetrennt und sie dann während der Montage des photovoltaischen Bauelements und deren Verbindung zu Batterien eingesetzt werden. Dabei erfolgt die Sicherung des Kontaktes der Stromabnehmerkontakte 2 mit der Oberfläche der Halbleiterplatte 1, die Verbindung und das Abdichten des photovoltaischen Bauelements innerhalb einer Phase bei der Erwärmung des montieren photovoltaischen Bauelements bis zu einer Temperatur von etwa 100-120°C und bis Anlegen einer äußeren Kraft bis 1 atm.

Die Stromabnehmerkontakte 2 können aus einem elektrisch leitfähigen, gebogenen Draht ausgeführt sein. Dabei kann der Draht periodisch und nicht periodisch gebogen sein, und zwar in Form einer Sinuslinie, eines Dreiecks, eines Trapezes, eines Rechtecks, einer flachen Spirale sowie verschiedene Kombinationen dieser geometrischen Figuren (Fig. 3). Die Drahtbiegung kann willkürlicher Form sein.

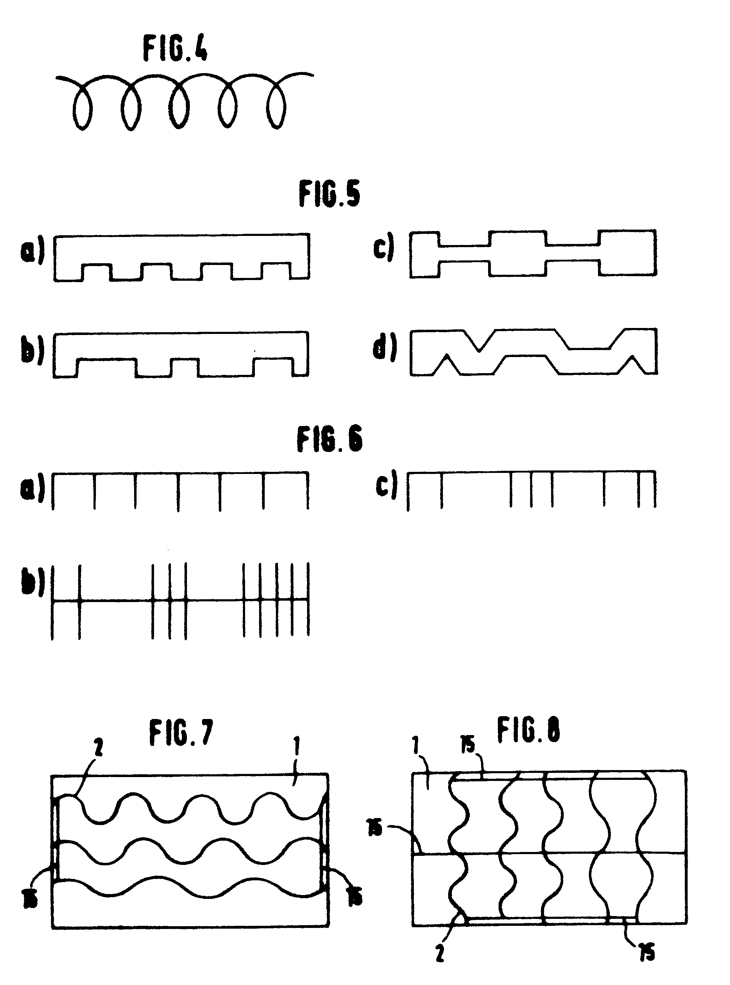

Die Stromabnehmerkontakte können auch in Form einer Schiene mit daran befestigten Drahtstücken ausgeführt werden, deren untere freie Enden mit der Oberfläche der Halbleiterplatte Kontakt aufnehmen (in Form einer "Bürste") (Fig. 6a, c). Dabei hat der Schritt zwischen den Drahtstücken keine besondere Bedeutung.

Die Drahtstücke können auch beidersetis einer gemeinsamen Schiene angeordnet werden (Fig. 6b).

Die Stromabnehmerkontakte können auch in Form einer zylindrischen Spirale (Fig. 4) sowie aus Blech mit Vorsprüngen und Ausnehmungen (Fig. 5) ausgeführt werden. Dabei haben die Lage der Vorsprünge und Ausnehmungen zueinander sowie ihre Form keine wesentliche Bedeutung. Es ist nur wichtig, durch den gespannten Zustand und die Elastizität der Stromabnehmerkontakte 2 einen zuverlässigen Kontakt mit der Oberfläche der Halbleiterplatte 1 zu gewährleisten.

Im photovoltaischen Bauelement zur Umwandlung von Lichtenergie in elektrische Energie können beiderseits der Halbleiterplatte 1 die Stromabnehmerkontakte 2 sowohl von einer Form, zum Beispiel, aus gebogenem Draht, als auch verschiedenste Kombinationen von Stromabnehmerkontakten 2 und zwar gebogener Draht - zylindrische Spirale - Kamm - Bürste usw. angeordnet werden.

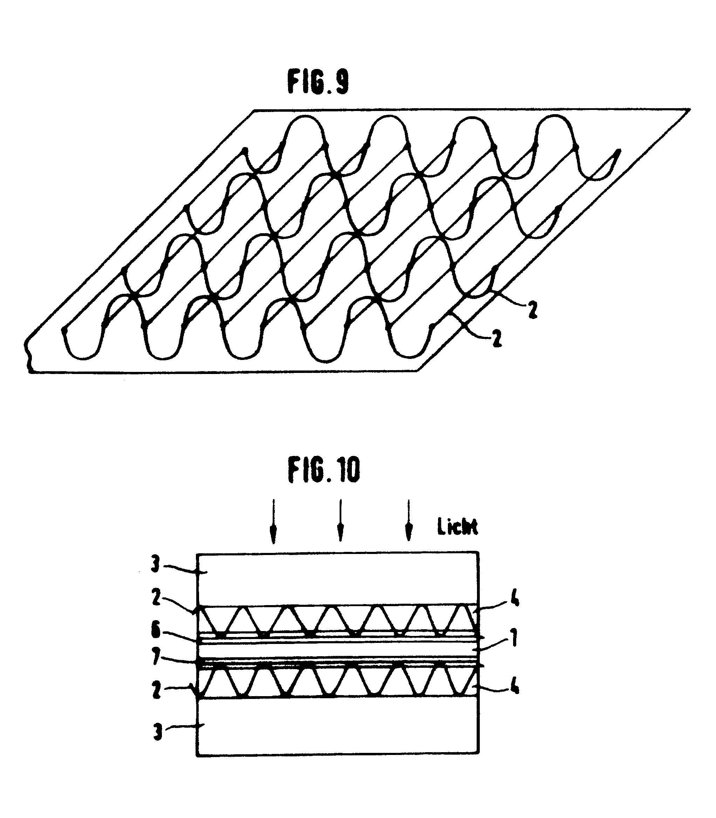

Die Stromabnehmerkontakte 2 können längs (Fig. 7) oder quer (Fig. 8) zur Halbleiterplatte 1 angeordnet werden, d.h. parallel zu einem von den Seitenpaaren der Halbleiterplatte, sowie, zum Beispiel, längs oder quer zur Vorderseite der Halbleiterplatte und jeweils umgekehrt zur Rückseite, d.h. parallel zu verschiedenen Seiten der Halbleiterplatte. Außerdem kann das elektrisch leitfähige Stromabnehmerelement in Form eines Netzes ausgeführt werden. Dabei kann das Netz aus Stromabnehmerkontakten in Form eines Drahtes, einer Spirale, einer "Bürste", aus flachen Stromabnehmerkontakten usw. zusammengesetzt werden. In Fig. 9 ist eine der möglichen Ausführungsformen eines Netzes aus einem Satz von gebogenen und geraden Drähten dargestellt. Dabei können die Drähte an den Kreuzungsstellen untereinander verbunden oder nicht verbunden werden. Die Befestigung an den Kreuzungsstellen gewährleistet jedoch eine Erhöhung der mechanischen Festigkeit, eine Reduzierung des Reihenwiderstandes sowie eine Vereinfachung der Montagetechnologie des photovoltaischen Bauelements.

Eine bedeutende Reduzierung des Übergangswiderstandes an den Berührungsstellen der Stromabnehmerkontakte 2 mit der Oberfläche der Halbleiterplatte 1 wird durch Auftragen eines elektrisch leitfähigen Antireflexbelages 6, mindestens auf die Vorderseite der Halbleiterplatte erreicht (Fig. 10), der durch eine hohe Konzentration an Ladungsträgern ($> 10^{20}$ cm$^{-3}$) gekennzeichnet ist. Als elektrisch leitfähiger Antireflexbelag werden bekannte Stoffe eingesetzt, die bei photovoltaischen Bauelementen eine breite Verwendung finden. Ist eine Aufhellung der Rückseite des photovoltaischen Bauelements möglich, dann ist es zweckmäßig, den Antireflexbelag auf beide Seiten der Halbleiterplatte aufzutragen, da er den Umwandlungswirkungsgrad des photovoltaischen Bauelements erhöht.

Bei Konstruktionen, bei denen das Licht nur von der Vorderseite der Halbleiterplatte 1 auf das photovoltaische Bauelement fällt, ist es zur Gewährleistung eines geringen Übergangswiderstandes zwischen dem Stromabnehmerkontakt und der Halbleiterplatte zweckmäßig, auf der Rückseite der Halbleiterplatte 1 eine hochlegierte, oberflächennahe Beschichtung mit demselben Leitfähigkeitstyp wie der der Halbleiterplatte 1 zu bilden bzw. eine Metallschicht aufzutragen. Dies ermöglicht es, den Kontaktwiderstand zu reduzieren und die Leerlaufspannung des photovoltaischen Bauelements zu erhöhen, was wiederum zur Erhöhung des Umwandlungswirkungsgrades führt.

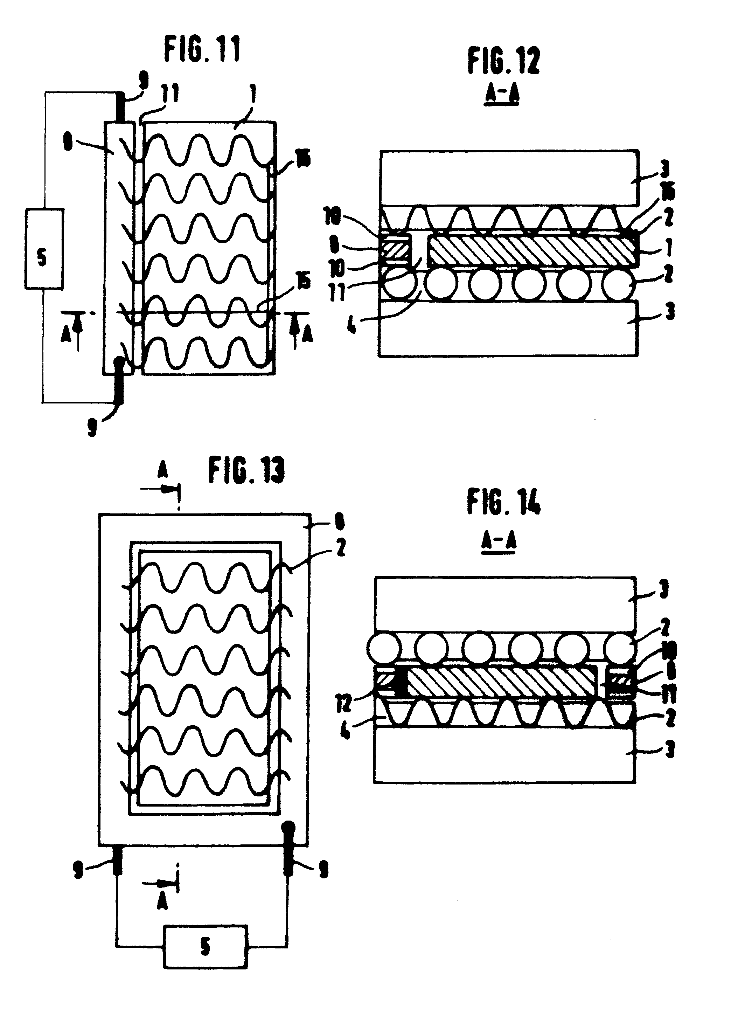

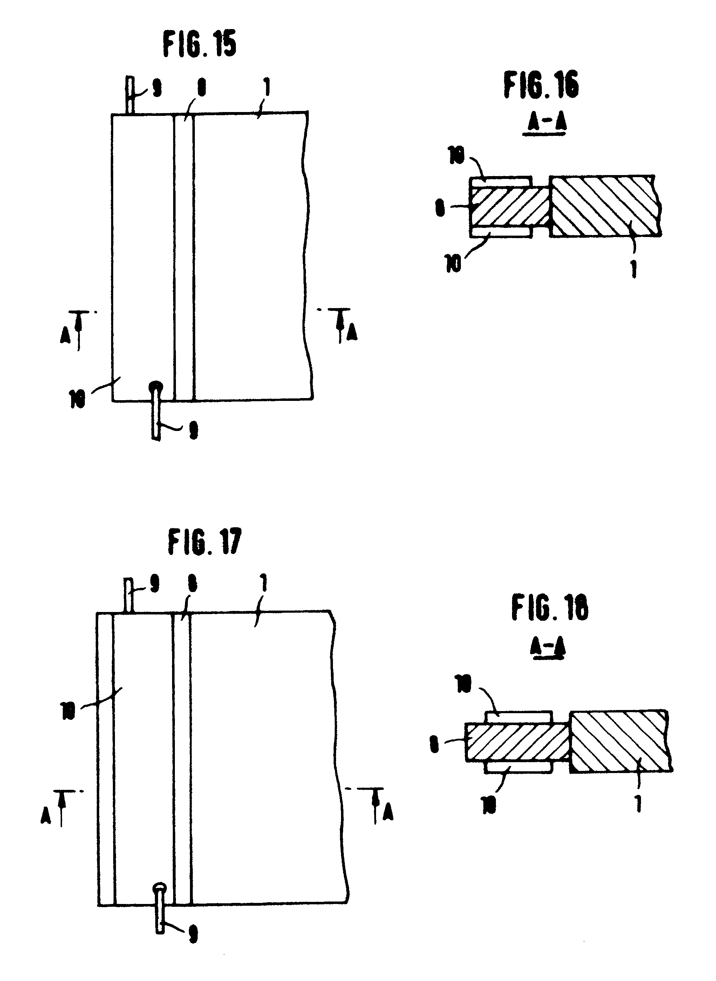

Die erfindungsgemäße Konstruktion der Stromabnehmerkontakte 2 ermöglicht es, die Verbindung der Kontakte wesentlich zu vereinfachen und auf den arbeitsaufwendigen Lötvorgang zu verzichten, der sich schwer automatisieren läßt. Zur Vereinfachung der Verbindung von Kontakten ist bei der Konstruktion nach Fig. 11 - 14 eine dielektrische Platte 8 vorgesehen, die in einer Ebene mit der Halbleiterplatte 1 angeordnet ist, und dazu mindestens auf einer Seite der Halbleiterplatte 1. Die dielektrische Platte 8 wird beiderseits mit einem elektrisch leitenden Stoff 10 beschichtet, mit dem die Stromabführungselektroden 9 verbunden, zum Beispiel gelötet werden. Die dielektrische Platte 8 wird mit einem Luftspalt 11 gegen die Halbleiterplatte 1 angeordnet. Es kann auch eine dielektrische Zwischenlage 12 zwischen die dielektrische Patte 8 und die Halbleiterplatte 1 eingefügt werden (Fig. 14). Zur Verhinderung des elektrischen Kontaktes des elektrisch leitenden Belages 10 der dielektrischen Platte 8 mit der Halbleiterplatte 1 kann die elektrisch leitende Beschichtung 10 auf die dielektrische Platte mit einem Abstand zum Rand der dielektrischen Platte 8 aufgetragen werden (Fig. 11-18).

Die an der Vorder- und Rückseite der Halbleiterplatte 1 angeordneten Stromabnehmerkontakte 2 werden jeweils von zwei Seiten auf die dielektrische Platte 8 aufgelegt und an das elektrisch leitende Material 10 durch die Andrückkraft der Schutzbeläge 3 und ihre eigene Elastizität angedrückt. Durch die Stromabführungselektroden 9 wird das photovoltaische Bauelement mit einem Belastungswiderstand 5 verbunden. Da die Dicke der dielektrischen Platte 8 vorzugsweise der Dicke der Halbleiterplatte 1 gleich oder um einen gewissen Wert größer ist, bewahren die Stromabnehmerkontakte 2 durch ihre Elastizität einen ständigen Kontakt mit der elektrisch leitenden Beschichtung 10 der dielektrischen Platte 8. Ein ausreichend geringer Kontaktwiderstand wird zwischen den Stromabnehmerelementen 2 und der elektrisch leitenden Beschichtung 10 durch die Nutzung als elektrisch leitende Beschichtung eines Materials mit hoher Konzentration an Ladungsträgern ($> 10^{20}$ cm$^{-3}$) und geringem Schichtwiderstand ($< 10^{-1}$ Ohm), zum Beispiel eines Metalls, gewährleistet. Im Falle der Verwendung einer dielektrischen Platte 8 werden die Stromabnehmerkontakte 2 durch eine Schiene an der anderen Seite der dieletrischen Platte bzw. bei Verwendung eines Netzes, an den drei anderen Seiten verbunden.

Eine bevorzugte Variante der Konstruktion des Verbindungselements (Fig. 13, 14) ist ein dielektrischer Rahmen 8, in dem die Halbleiterplatte 1 mit einem Luftspalt 11 bzw. einer dielektrischen Einlage 12 angeordnet ist. In diesem Fall weist der dielektrische Rahmen 8 ebenfalls auf beiden Seiten eine elektrisch leitfähige Beschichtung 10 auf, mit der die Stromabnehmerkontakte 2 in Kontakt stehen. Dabei kann die elektrisch leitfähige Beschichtung 10 die dielektrische Platte ebenfalls nicht ganzflächig bedecken, wie es oben beschrieben ist (Fig. 15-18). Solch eine Konstruktion, die alle oben angeführten Vorteile der oben beschriebenen dielektrischen Platte aufweist, die an der Seite der Halbleiterplatte angeordnet ist, ermöglicht es, auf den Lötvorgang ganz zu verzichten und sowohl den Herstellungsvorgang von einzelnen photovoltaischen Bauelementen als auch der Montage von Batterien auf der Grundlage von solchen photovoltaischen Bauelementen zu automatisieren. Dies wird dadurch erreicht, daß zum Beispiel bei der beiderseits eine elektrisch leitfähige Beschichtung aufweisenden dielektrischen Platte 8 einige Öffnungen ausgeführt werden, in die die Halbleiterplatten 1 mit dem aufgetragenen Antireflexbelag 6 und der elektrisch leitfähigen Beschichtung 7 eingefügt werden. Auf den Halbleiterplatten 1 werden von oben und von unten die vorbereiteten Bänder aus dem optisch transparenten Polymer 4 mit den darin eingeschmolzenen Stromabnehmerkontakten 2 angebracht. Die Polymerbänder 4 können aus einem optisch transparenten, hermetisch abschließenden Adhäsionsstoff gefertigt bzw. mit einem solchen Material von oben und von unten beschichtet werden. Von oben werden auf das Polymermaterial 4 die Schutzbeläge 4 aufgelegt, die aus Glas oder zum Beispiel Lawsan ausgeführt sind, das die Elastizität des Schutzbelages gewährleistet.

Nach der Montage wird die ganz Konstruktion des photovoltaischen Bauelements bis zum Fließpunkt des Polymers erwärmt (etwa 100 - 120 °C). Mittels der angelegten Außenkraft (bis 1 atm.) fließt das Polymer aus den Öffnungen, wo die Halbleiterplatte 1 und die dielektrische Platte 8 untergebracht sind, in den zwischen ihnen gebildeten Spalt bzw. in technologische Spalte. Da die Temperatur und der Druck gering sind, erfolgt keine unerwünschte Trennung der Halbleiterplatte 1 und der dielektrischen Platte 8. Bei der Erwärmung und dem Andrücken erfolgt auch die Adhäsionsverbindung des Schutzbelages 3 und der Halbleiterplatte 1 mit dem hermetisch abschließenden Adhäsionspolymer, das auf den Polymerblock 4 aufgetragen bzw. aus dem der Polymerblock 4 ausgeführt wird.

Die erfindungsgemäßen photovoltaischen Bauelemente werden zur Montage von Batterien auf ihrer Grundlage eingesetzt.

Dabei wird leicht jegliche Verbindung von photovoltaischen Bauelementen - sowohl die Reihenschaltung als auch die Parallelschaltung - gewährleistet.

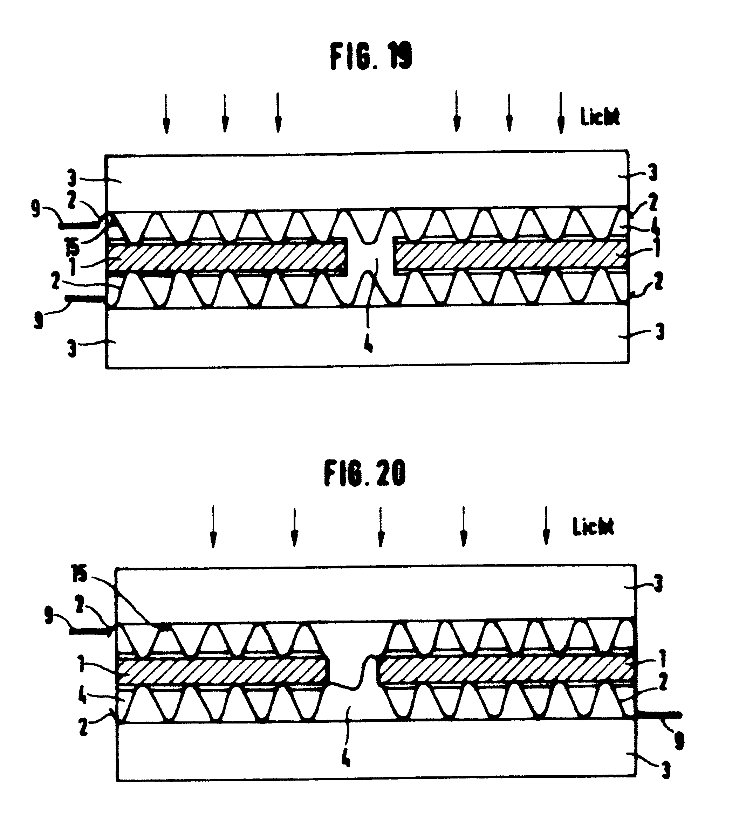

Fig. 19 zeigt in schematischer Darstellung die Parallelschaltung von zwei photovoltaischen Bauelementen. In diesem Fall werden die an der Vorderseite der Halbleiterplatte 1 des ersten Photowandlers angeordneten Stromabnehmerkontakte 2 elektrisch mit den an der Vorderseite der Halbleiterplatte 1 des anderen Photowandlers angeordneten Stromabnehmerkontakten 2 verbunden. Dabei werden jeweils die an den Rückseiten beider Halbleiterplatten angeordneten Stromabnehmerkontakte 2 elektrisch verbunden. Die freien Enden der Stromabnehmerkontakte 2 beider photovoltaischer Bauelemente sind an die jeweiligen Stromabführungselektroden 9 angeschlossen. Die freien Enden der Stromabnehmerkontakte 2 beider photovoltaischer Bauelemente sind an die jeweiligen Stromabführungseletroden 9 angeschlossen.

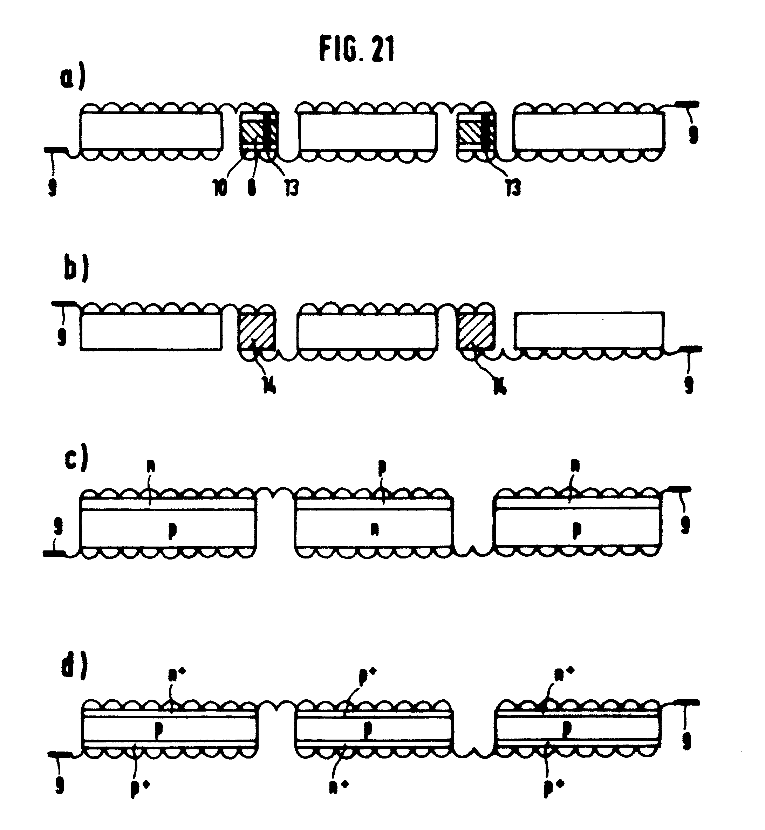

Bei der Reihenschaltung (Fig. 20) von photovoltaischen Bauelementen werden die an der Rückseite der Halbleiterplatte 1 des ersten photovoltaischen Bauelements angeordneten Stromabnehmerkontakte 2 elektrisch mit den an der Vorderseite der Halbleiterplatte 1 des nächsten photovoltaischen Bauelements angeordneten Stromabnehmerkontakten 2 verbunden. Die freien Enden der Stromabnehmerkontakte 2 beider photovoltaischer Bauelemente sind an die jeweiligen Stromabführungselektroden 9 angeschlossen. Fig. 20 zeigt diese Verbindung in schematischer Darstellung.

Zur Reduzierung des Widerstandes der Stromabnehmerkontakte 2 kann bei der Vorrichtung gemäß den Figuren 7, 8, 11, 12, 19 und 20 ein metallischer Leiter 15 in Form eines Drahtes oder eines metallisierten Dielektrums beliebiger Form vorgesehen werden, der mit den Stromabnehmerkontakten 2 in elektrischem Kontakt steht. Dieser Leiter 15 kann sowohl auf der Fläche als auch an den Rändern der Siliziumplatte angeordnet sein und mit dem metallisierten Rahmen 8 in elektrischem Kontakt stehen. Im Falle der Fig. 11, 12 sind die beiden elektrischen Leiter 15 am Kreuzungspunkt miteinander und einer der beiden Leiter 15 ist mit der metallisierten dielektrischen Platte 8 verbunden.

Fig. 21 (a, b, c, d) zeigt mögliche Varianten der Reihenschaltung der Bauelemente zu einer Batterie. In Fig. 21a wird zur Reihenschaltung von photovoltaischen Bauelementen in den dielektrischen Platten 8 mit der Metallbeschichtung 10 ein System von Schnitten, Bohrungen und Stegen 13 vorgesehen, durch die die Metallbeschichtungen verbunden werden.

Anstatt einer dielektrischen Platte kann eine ganzflächige Metallplatte 14 verwendet werden, wodurch die Vorder- und Rückseite von zwei in Reihe geschalteten photovoltaischen Bauelementen verbunden werden (Fig. 21b).

Fig. 21c zeigt eine Batterie, die aus photovoltaischen Bauelementen zusammengesetzt ist, deren Basishalbleiter unterschiedliche Leitfähigkeitstypen aufweisen.

Fig. 21d zeigt eine Batterie, die aus in Reihe geschalteten photovoltaischen Bauelementen mit einem Leitfähigkeitstyp und einer Rückseitenempfindlichkeit zusammengestzt ist, daß sich der Umwandlungswirkungsgrad bei Aufhellung des photovoltaischen Bauelements von der Rückseite kaum vom Umwandlungwirkungsgrad bei seiner Aufhellung von der Vorderseite unterscheidet.

Sowohl bei Reihenschaltung, als auch bei Parallelschaltung von photovoltaischen Bauelementen zu einer Batterie können die Kontaktsysteme der photovoltaischen Bauelemente herausgeführt und verbunden werden. Die photovoltaischen Bauelemente wurden erfindungsgemäß aus verschiedenen Materialien hergestellt und durch Versuche mit Bauelementen verglichen, die aus denselben Materialien, jedoch nach den bekannten Technologien hergestellt wurden.

Diese Versuche zeigten, daß der Umwandlungswirkungsgrad der erfindungsgemäßen photovoltaischen Bauelemente bei einer Aufhellung von 1000 W/m$^2$ 16-18 % beträgt, während der Umwandlungswirkungsgrad von bekannten photovoltaischen Bauelementen 12 % beträgt. Die erfindungsgemäßen photovoltaischen Bauelemente wurden innerhalb von 60 Tagen bei einer Temperatur von 80°C ohne Änderung des Wirkungsgrades betrieben, was 10 Betriebsjahren bei Raumtemperatur entspricht.

## Patentansprüche

1. Photovoltaisches Bauelement, das eine photoempfindliche Halbleiterplatte (1) mit Barrierestruktur, beiderseits der Halbleiterplatte (1) angeordnete, elektrisch leitfähige Stromabnehmerkontakte (2), beiderseits der Halbleiterplatte (1) angeordnete Schutzbeläge (3) und Stromabführungselektroden (9) aufweist, dadurch gekennzeichnet, daß mindestens die an der Vorderseite der Halbleiterplatte (1) angeordneten elektrisch leitfähigen Stromabnehmerkontakte (2) in Form von elektrisch verbundenen und aufeinanderfolgenden Abschnitten ausgeführt sind, die mit der Oberfläche der Halbleiterplatte (1) in Kontakt bzw. nicht in Kontakt stehen.

2. Photovoltaisches Bauelement nach Anspruch 1, dadurch gekennzeichnet, daß die elektrisch leitfähigen Stromabnehmerkontakte (2) beiderseits einer photoempfindlichen Halbleiterplatte (1) angeordnet sind.

3. Photovoltaisches Bauelement nach Anspruch 1 oder 2, dadurch gekennzeichnet, daß die elektrisch leitfähigen Stromabnehmerkontakte (2) aus einem gebogenen Draht ausgeführt sind.

4. Photovoltaisches Bauelement nach Anspruch 1 oder 2, dadurch **gekennzeichnet**, daß die elektrisch leitfähigen Stromabnehmerkontakte (2) in Form einer zylindrischen Feder ausgeführt sind.

5. Photovoltaisches Bauelement nach Anspruch 1 oder 2, dadurch **gekennzeichnet**, daß der elektrisch leitfähige Stromabnehmerkontakt (2) aus Blech in Form eines Kammes ausgeführt ist, der Vorsprünge und Ausnehmungen aufweist.

6. Photovoltaisches Bauelement nach Anspruch 1 oder 2, dadurch **gekennzeichnet**, daß die elektrisch leitfähigen Stromabnehmerkontakte (2) in Form einer Bürste ausgeführt sind, die aus einer elektrisch leitfähigen Schiene und mit ihr verbundenen Drahtstücken besteht.

7. Photovoltaisches Bauelement nach Anspruch 1, dadurch **gekennzeichnet**, daß die elektrisch leitfähigen Stromabnehmerkontakte (2) in einem Block (4) aus optisch transparentem Polymer derart befestigt sind, daß mindestens die Abschnitte (a) der Stromabnehmerkontakte (2), die mit der Halbleiterplatte (1) in Kontakt stehen, aus dem Polymerblock (4) hinausragen.

8. Photovoltaisches Bauelement nach einem der Ansprüche 1 bis 7, dadurch **gekennzeichnet**, daß auf die obere und die untere Oberfläche des Polymerblocks (4) eine Schicht aus einem Adhäsionspolymermittel aufgetragen ist.

9. Photovoltaisches Bauelement nach einem der Ansprüche 1 bis 7, dadurch **gekennzeichnet**, daß als Polymerblockstoff, in den die elektrisch leitfähigen Stromabnehmerkontakte (2) eingeschmolzen sind, optisch transparente Adhäsionspolymermittel verwendet werden. 10. Photovoltaisches Bauelement nach einem der Ansprüche 1

10. bis 9, dadurch **gekennzeichnet**, daß mindestens an der Vorderfläche der Halbleiterplatte (1) ein elektrisch leit-fähiger Antireflexbelag (6) aufgetragen ist, mit dem die elektrisch leitfähigen Stromabnehmerkontakte (2) in Kontakt stehen.

11. Photovoltaisches Bauelement nach einem der Ansprüche 1 bis 10, dadurch **gekennzeichnet**, daß auf die Rückseite der Halbleiterplatte (1) eine Metallschicht (7) aufgetragen ist, mit der die Stromabnehmerkontakte (2) in Kontakt stehen.

12. Photovoltaisches Bauelement nach einem der Ansprüche 1 bis 10, dadurch **gekennzeichnet**, daß die Rückseiteder Halbleiterplatte (1) eine hochlegierte Schicht (7) mit dem Leitfähigkeitstyp der Halbleiterplatte aufweist, wobei die Stromabnehmerkontakte (2) mit dieser Schicht in Kontakt stehen.

13. Photovoltaisches Bauelement nach einem der Ansprüche 1 bis 12, dadurch **gekennzeichnet**, daß sich die elektrisch leitfähigen Stromabnehmerkontakte (2) über die ganze Oberfläche der Halbleiterplatte (1) erstrecken.

14. Photovoltaisches Bauelement nach einem der Ansprüche 1 bis 12, dadurch **gekennzeichnet**, daß sich die elektrisch leitfähigen Stromabnehmerkontakte (2) über die ganze Oberfläche der Halbleiterplatte (1) erstrecken und parallel zu einem der Seitenpaare der Halbleiterplatte (1) angeordnet sind.

15. Photovoltaisches Bauelement nach einem der Ansprüche 1 bis 12, dadurch **gekennzeichnet**, daß sich die elektrisch leitfähigen Stromabnehmerkontakte (2) über die Oberfläche der Halbleiterplatte (1) in Form eines Netzes erstrecken.

16. Photovoltaisches Bauelement nach einem der Ansprüche 13 bis 15, dadurch **gekennzeichnet**, daß mindestens auf einer Seite der Halbleiterplatte (1) in einer Ebene mit ihr mit einem dielektrischen Spalt zu ihr eine dielektrische Platte (8) angeordnet ist, die die elektrisch leitfähigen Beschichtungen (10) an der Vorder- und Rückseite aufweist, mit denen die Stromabführungselektroden (9) verbunden sind und die elektrisch leitfähigen Stromabnehmerkontakte (2) elektrisch in Kontakt stehen.

17. Photovoltaisches Bauelement nach Anspruch 16, dadurch **gekennzeichnet**, daß die dielektrische Platte (8) in Form eines Rahmens ausgeführt ist, der mit einem dielektrischen Spalt rund um die Halbleiterplatte (1) herum und in einer Ebene mit ihr angeordnet ist.

18. Photovoltaisches Bauelement nach einem der vorstehenden Ansprüche, **gekennzeichnet** durch wenigstens einen ersten metallischen Leiter (15), der mit den Stromabnehmerkontakten (2) verbunden ist.

19. Photovoltaisches Bauelement nach Anspruch 18, **gekennzeichnet** durch wenigstens einen zweiten elektrischen Leiter (15), der den ersten elektrischen Leiter (15) kreuzt und am Kreuzungspunkt mit dem ersten elektrischen Leiter (15) verbunden ist.

20. Photovoltaisches Bauelement nach Anspruch 18 oder 19, dadurch **gekennzeichnet**, daß wenigstens einer der beiden Leiter mit der metallisierten dielektrischen Platte (8) verbunden ist.

21. Batterie, die mindestens zwei parallel geschaltete photovoltaische Bauelemente gemäß einem der Ansprüche 1 bis 20 aufweist, dadurch **gekennzeichnet**, daß die auf der Vorderseite der Halbleiterplatte (1) der ersten Vorrichtung angeordneten, elektrisch leitfähigen Stromabnehmerkontakte (2) elektrisch mit den auf der Vorderseite der Halbleiterplatte (1) des nächsten photovoltaischen Bauelements angeordneten Stromabnehmerkontakten (2) verbunden, und jeweils die an den Rückseiten der Halbleiterplatten beider photovoltaischen Bauelemente angeordneten Stromabnehmerkontakte (2) verbunden sind, wobei die freien Enden beider photovoltaischen Bauelemente an die jeweiligen Stromabführungselektroden (9) angeschlossen sind.

22. Batterie, die mindestens zwei in Reihe geschaltete photovoltaische Bauelemente gemäß einem der Ansprüche 1 bis 20 aufweist, dadurch **gekennzeichnet**, daß die auf der Rückseite der Halbleiterplatte (1) des ersten photovoltaischen Bauelements angeordneten, elektrisch leitfähigen Stromabnehmerkontakte (2) elektrisch mit den auf der Vorderseite der Halbleiterplatte (1) des nächsten photovoltaischen Bauelements angeordneten, elektrisch leitfähigen Stromabnehmerkontakten (2) verbunden sind, wobei die auf der Vorderseite der Halbleiterplatte (1) des ersten photovoltaischen Bauelements angeordneten Stromabnehmerkontakte (2) und die auf der Rückseite der Halbleiterplatte (1) des zweiten photovoltaischen Bauelements angeordneten Stromabnehmerkontakte (2) an die jeweiligen Stromabnehmerelektroden (9) angeschlossen sind.

# FIG. 1

Licht

# FIG. 2

# FIG. 3

a)

b)

c)

d)

e)

f)

g)

h)

i)

j)

FIG.4

FIG.5

a)

b)

c)

d)

FIG.6

a)

b)

c)

FIG.7

FIG.8

## FIG.9

## FIG.10

# FIG.11

# FIG.12
## A-A

# FIG.13

# FIG.14
## A-A

FIG. 15

FIG. 16
A-A

FIG. 17

FIG. 18
A-A

## FIG. 19

## FIG. 20

# FIG. 21

a)

b)

c)

d)

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-A-3 317 309 (MESSERSCHMITT-BÖLKOW-BLOHM GmbH) * Seite 9, Zeile 24 - Seite 11, Zeile 7; Abbildungen 1,2 * --- | 1,11,14 | H 01 L 31/0224 H 01 L 31/05 H 01 L 31/048 |
| A | DE-A-2 903 102 (R. DAHLBERG) * Das ganze Dokument * --- | 1,7,15 | |
| A | US-A-4 301 322 (J.A. AMICK) * Das ganze Dokument * --- | 1,3,22 | |
| A | US-A-4 083 097 (E. ANAGNOSTOU et al.) --- | | |
| D,A | US-A-4 380 112 (R.G. LITTLE) ----- | | |

| | RECHERCHIERTE SACHGEBIETE (Int. Cl.5) |
|---|---|
| | H 01 L |

Der vorliegende Recherchenbericht wurde für alle Patentansprüche erstellt

| Recherchenort | Abschlußdatum der Recherche | Prüfer |
|---|---|---|
| DEN HAAG | 17-10-1990 | VISENTIN A. |